# EUROPÄISCHE PATENTSCHRIFT

(11) **EP 0 546 997 B1**
(45) Veröffentlichungstag und Bekanntmachung des Hinweises auf die Patenterteilung: **02.02.2000**
(21) Anmeldenummer: 92810945.3
(22) Anmeldetag: 02.12.1992
(51) Int. Cl.: G03F 7/039, C08F 12/22

(54) **Strahlungsempfindliche Polymere**
Radiation-sensitive polymer
Polymères sensibles aux radiations

(30) Priorität: 10.12.1991 CH 362692
(43) Veröffentlichungstag der Anmeldung: 16.06.1993
(73) Patentinhaber: ARCH SPECIALTY CHEMICALS, INC., Norwalk, Connecticut 068546-4500 (US)
(72) Erfinder: Steinmann, Alfred Dr., CH-1724 Praroman (CH)
(74) Vertreter: Klunker . Schmitt-Nilson . Hirsch

(56) Entgegenhaltungen:
- EP-A- 0 440 374
- EP-A- 0 467 841
- DE-A- 3 317 919

## Beschreibung

Gegenstand der vorliegenden Erfindung sind strahlungsempfindliche Polymere, die auf einen olefinisch ungesättigten Substituenten enthaltenden Phenylessigsäureestern basieren, Zusammensetzungen enthaltend diese Polymere, Verfahren zur Herstellung von Abbildungen unter Verwendung dieser Zusammensetzungen, sowie die Verwendung der Polymere als Positiv-Resists.

Positiv arbeitende, strahlungsempfindliche Zusammensetzungen und deren Verwendung als Photoresist sind bekannt. Neben einer hohen Empfindlichkeit im UV-Strahlungsbereich werden von solchen Photoresists eine einfache Entwickelbarkeit und gute Ätzresistenz gefordert.

Beispielsweise werden in US-A 3,779,778 positiv arbeitende Photoresists beschrieben, enthaltend eine wasserlösliche organische Verbindung, die bestimmte säurespaltbare Bindungen aufweist, und eine bei aktinischer Bestrahlung säurebildende Verbindung. Diese Photoresists können nur in relativ stark alkalischen wässrigen Lösungen entwickelt werden, und sie sind wenig temperaturstabil.

Die aus EP-A 254 853 bekannten, positiv arbeitenden Photoresists ergeben nach der Belichtung und Entwicklung Bilder mit einer hohen thermischen Stabilität, doch sind sie relativ wenig lichtempfindlich und nur in stark alkalischen, wässrigen Lösungen entwickelbar.

JP-A-2-25850 offenbart strahlungsempfindliche Zusammensetzungen mit hoher Auflösung und hoher Empfindlichkeit im DUV-Bereich, die Polymere und eine Verbindung, die bei Bestrahlung Säure freisetzt, enthalten. Die Polymere enthalten eine Acetal-Gruppe oder eine Thioacetal-Gruppe in der Seitenkette.

Es wurde nun gefunden, dass bestimmte andere Polymere, basierend auf Phenylessigsäureestern, die einen olefinisch ungesättigten Substituenten enthalten, vorteilhaft für strahlungsempfindliche, positiv arbeitende Zusammensetzungen verwendet werden können. Die daraus hergestellten Photoresists weisen eine bessere Empfindlichkeit gegenüber aktinischen Strahlen auf. Insbesondere im DUV-Bereich (DUV: deep ultra-violet; Bereich zwischen 200 und 300 nm) haben diese Resists eine hohe Transparenz und Empfindlichkeit. Darüber hinaus lassen sie sich nach der Belichtung unter sehr milden Entwicklungsbedingungen, beispielsweise in einem sehr schwach alkalischen Medium, wie 1 gew.%-ige, wässrige NaHCO₃-Lösung, entwickeln. Dabei können Schichten mit Submikron-Auflösung hergestellt werden, so dass die Photoresists auch zur Herstellung von Halbleitern verwendet werden können. Ausserdem zeigen die aus den erfindungsgemässen Photoresists hergestellten Strukturen eine hohe thermische Stabilität.

Gegenstand vorliegender Erfindung sind somit neue Polymere mit einem Molekulargewicht (M_{w}) von 10³ bis 10⁶, gemessen mittels Gelpermeationschromatographie, enthaltend, bezogen auf die Gesamtmenge der im Polymer vorhandenen Strukturelemente, 100 bis 10 Mol-% des wiederkehrenden Strukturelementes der Formel I 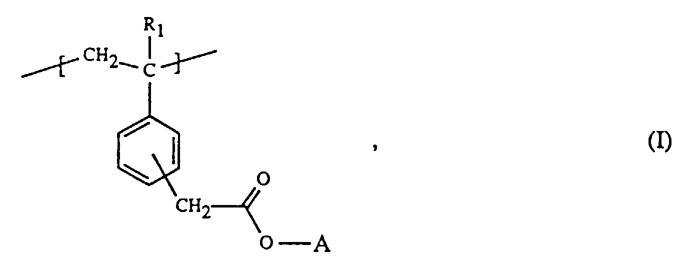 wobei A für einen Rest der Formel Ia 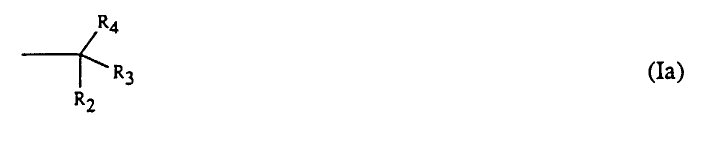 steht, und 90 bis 0 Mol-% des wiederkehrenden Strukturelementes der Formel II 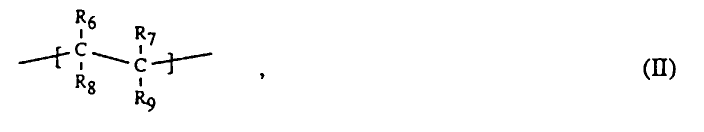 worin
- R₁: Wasserstoff, Methyl oder Halogen,
- R₂: Wasserstoff oder Methyl,
- R₃: Wasserstoff, C₁-C₆-Alkyl oder C₆-C₁₂-Aryl und
- R₄: C₁-C₆-Alkyl, unsubstituiertes oder mit C₁-C₄-Alkyl, C₁-C₄-Alkoxy, C₆-C₁₂-Aryl, Halogen oder Nitrogruppen substituiertes C₆-C₁₂-Aryl darstellt,
- R₆ und R₇: unabhängig voneinander jeweils Wasserstoff, unsubstituiertes oder mit Halogen, Cyano- oder Nitrogruppen substituiertes C₁-C₄-Alkyl oder ein unsubstituiertes oder mit Halogen, C₁-C₄-Alkoxy-, Hydroxy-, Cyano- oder Nitrogruppen substituiertes Phenyl oder Naphthyl bedeuten,
- R₈ und R₉: unabhängig voneinander jeweils Wasserstoff oder Halogen, unsubstituiertes oder durch Halogen, Cyano- oder Nitrogruppen substituiertes C₁-C₁₂-Alkyl, unsubstituiertes oder durch Halogen, Hydroxy-, Cyano-, Nitrogruppen, C₁-C₄-Alkyl oder C₁-C₄-Alkoxy substituiertes Phenyl, Naphthyl oder Benzyl oder einen der folgenden Reste -OR₁₀, -COOR₁₁ oder -COR₁₂ bedeuten, wobei R₁₀ und R₁₁ unabhängig voneinander jeweils Wasserstoff, unsubstituiertes oder durch Halogen, Cyano- oder Nitrogruppen substituiertes C₁-C₁₂-Alkyl, unsubstituiertes oder durch Halogen, Cyano-, Nitrogruppen, C₁-C₄-Alkyl oder C₁-C₄-Alkoxy substituiertes Phenyl oder Naphthyl bedeuten und R₁₂ die gleiche Bedeutung wie R₁₀ hat und ausserdem für den Rest 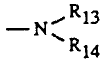 steht, worin R₁₃ und R₁₄ unabhängig voneinander die gleiche Bedeutung wie R₁₀ haben.

Die erfindungsgemässen Polymere weisen vorzugsweise ein Molekulargewicht (M_{w}) von 5 000 bis 500 000, insbesondere von 15 000 bis 150 000, auf.

Vorzugsweise enthalten die Polymere 100 bis 25 Mol-% des wiederkehrenden Strukturelementes der Formel I und 75 bis 0 Mol-% des wiederkehrenden Strukturelementes der Formel II.

Bevorzugt sind Polymere, worin in der Formel I R₁ Wasserstoff oder Methyl bedeutet und die Gruppe -CH₂-COOA am Ring in para-Stellung gebunden ist, und worin in der Formel Ia R₂ Wasserstoff oder Methyl, R₃ Wasserstoff oder C₁-C₄-Alkyl und R₄ Wasserstoff oder C1-C4-Alkyl darstellt.

Insbesondere bevorzugt sind Polymere, worin in der Formel I R₁ Wasserstoff oder Methyl bedeutet und die Gruppe -CH₂-COOA am Ring in para-Stellung gebunden ist, und worin in der Formel Ia R₂ und R₃ unabhängig voneinander jeweils Wasserstoff oder Methyl bedeuten und R₄ C₁-C₄-Alkyl darstellt.

Ganz besonders bevorzugt sind Polymere, worin in der Formel I R₁ Wasserstoff oder Methyl bedeutet und die Gruppe -CH₂-COOA am Ring in para-Stellung gebunden ist, und worin A einen Rest der Formel 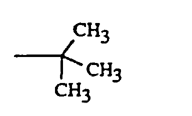 bedeutet.

Stellt ein Substituent C₁-C₄-Alkyl, C₁-C₆-Alkyl oder C₁-C₁₂-Alkyl dar, so kann dieser geradkettig oder verzweigt sein. Beispielsweise handelt es sich bei C₁-C₄-Alkyl um Methyl, Ethyl, n-Propyl, Isopropyl, n-Butyl, sec-Butyl, Isobutyl oder tert.-Butyl, bei C₁-C₆-Alkyl zusätzlich um Pentyl oder Hexyl und bei C₁-C₁₂-Alkyl darüber hinaus um Heptyl, Octyl, Nonyl, Decyl, Undecyl oder Dodecyl. Als substituiertes Alkyl kommen beispielsweise 2-Chlorethyl, 2-Nitroethyl, 6-Nitrohexyl oder 9-Bromnonyl in Frage.

Bedeutet ein Substituent Halogen, so handelt es sich um Fluor, Chlor, Brom oder Jod, insbesondere aber um Chlor und Brom.

Bedeutet ein Substituent C₆-C₁₂-Aryl, so handelt es sich um Phenyl, Biphenyl oder Naphthyl, die gegebenenfalls ein- oder mehrfach substituiert sein können, wobei als Substituenten hierbei zum Beispiel Halogenatome, vorzugsweise Chlor- oder Bromatome, Methyl, Ethyl, Methoxy, Ethoxy oder Nitrogruppen in Betracht kommen. Geeignete substituierte Aryle sind beispielsweise o-, m- und p-Tolyl, Xylyl, o-, m- und p-Chlorphenyl, o-Nitrophenyl, 2,4-Dichlorphenyl und 2-Chlornaphthyl.

Als C₁-C₄-Alkoxysubstituenten kommen beispielsweise Methoxy, Ethoxy, n-Propoxy oder n-Butoxy in Frage.

Die erfindungsgemässen Polymere können hergestellt werden, indem man mindestens eine Verbindung der Formel III 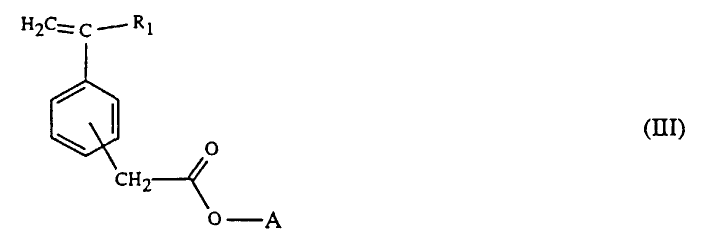 oder Gemische enthaltend mindestens eine Verbindung der Formel III und bis zu 90 Mol-%, vorzugsweise bis zu 75 Mol-%, mindestens einer Verbindung der Formel IV 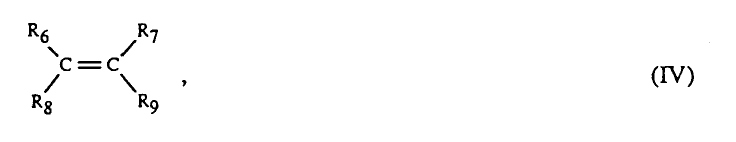 worin R₁, R₆, R₇, R₈, R₉ und A die oben angegebene Bedeutung haben, in an sich bekannter Weise radikalisch polymerisiert.

Die radikalische Polymerisation kann unter Anwendung verschiedener Techniken durchgeführt werden. Diese sind beispielsweise von S. Sandler und W. Karo in "Polymer Synthesis" Vol. 1-3, 1968, Academic Press, New York, beschrieben worden. Übliche Polymerisationsverfahren sind beispielsweise Polymerisation in der Masse oder in Lösungsmitteln, Emulsions-, Suspensions-oder Fällungspolymerisation.

Die Verbindungen der Formel III können in an sich bekannter Weise hergestellt werden, indem beispielsweise eine Verbindung der Formel Va 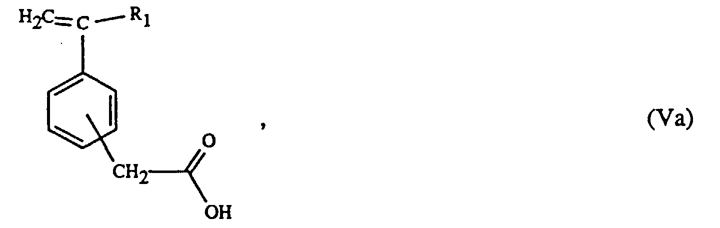 worin R₁ die gleiche Bedeutung wie oben angegeben hat, mit einer Verbindung der Formel VIb

HO―A , (VIb)

worin A die oben angegebene Bedeutung hat,
in einem sauren Medium zu einer Verbindung der Formel III umsetzt,
oder indem beispielsweise eine Verbindung der Formel Vb 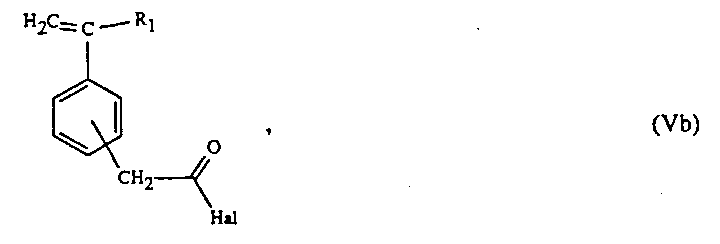 worin R₁ die gleiche Bedeutung wie oben angegeben hat und Hal ein Halogenatom, insbesondere Chlor und Brom, bedeutet, mit einer Verbindung der oben angegebenen Formel VIb in einem basischen Medium zu einer Verbindung der Formel III umsetzt.

Die Verbindungen der Formel Va sind beispielsweise aus US 4,499,300 bekannt. Die Verbindungen der Formel Vb sind die Säurehalogenide der Formel Va. Beispiele für Verbindungen der Formel Va und Vb sind 4- oder 2-Vinylphenylessigsäure, 4-(1'-Chlor)-vinylphenylessigsäure, 4-Isopropenylphenylessigsäure und 4-Isobutenylphenylessigsäure, sowie die entsprechenden Säurechloride.

Die Verbindungen der Formel VIb stellen ebenfalls bekannte Verbindungen dar, die zum Teil im Handel erhältlich sind. Beispiele hierfür sind tertäre Alkohole, wie tert.-Butanol, sowie Benzylalkohol oder Nitrobenzylalkohol.

Das saure Medium der Reaktionslösung kann beispielsweise dadurch hergestellt werden, indem man zur Reaktionslösung einige Tropfen konz. Salzsäure oder Schwefelsäure zugibt.

Das basische Medium der Reaktionslösung kann beispielsweise dadurch hergestellt werden, indem man zur Reaktionslösung äquimolare Mengen Triethylamin oder Pyridin zugibt.

Die Umsetzung der Verbindungen der Formel Va bzw. Vb mit den Verbindungen der Formel VIb wird vorzugsweise unter einem Inertgas, insbesondere unter Stickstoff, durchgeführt, wobei leicht erhöhte Temperaturen, etwa 25 bis 80 °C, angewendet werden.

Die Verbindungen der Formel IV sind bekannt und zum Teil im Handel erhältlich. Neben Olefinen, wie beispielsweise Ethylen oder Propylen, sind als Beispiele für Verbindungen der Formel IV insbesondere die Vinylverbindungen zu nennen. Beispiele solcher Monomere sind die Styroltypen, wie beispielsweise Styrol, α-Methylstyrol, p-Methylstyrol, p-Hydroxystyrol, p-Acetylstyrol oder p-Hydroxyphenylstyrol, Ester oder Amide von α,β-ungesättigten Säuren, wie beispielsweise Acrylsäuremethylester, Acrylsäureamid, die entsprechenden Methacrylverbindungen, Maleinsäuremethylester, Maleinimid, p-Hydroxyphenylmaleinimide oder 4-Vinylbenzoesäure-tert.-butylester, halogenhaltige Vinylverbindungen, wie beispielsweise Vinylchlorid, Vinylfluorid, Vinylidenchlorid oder Vinylidenfluorid, Vinylester, wie beispielsweise Vinylacetat, oder Vinylether, wie beispielsweise Methylvinylether oder Butylvinylether.

Weitere geeignete Verbindungen sind beispielsweise die Allylverbindungen, wie Allylchlorid, Allylbromid oder Allylcyanid.

Die Polymerisation wird in der Regel durch einen der üblichen Initiatoren der radikalischen Polymerisation eingeleitet. Dazu zählen thermische Initiatoren, wie Azoverbindungen, beispielsweise Azoisobutyronitril (AIBN), oder Peroxide, beispielsweise Benzoylperoxid, oder Redoxinitiatorsysteme, wie eine Mischung von Eisen(III)acetyl-acetonat, Benzoin und Benzoylperoxid, oder photochemische Radikalbildner, wie Benzoin oder Benzilmethylketal.

Die Polymerisation wird bevorzugt in Lösung durchgeführt. Die Reaktionstemperatur bewegt sich im allgemeinen im Bereich von 10 bis 200 °C, vorzugsweise zwischen 40 und 150 °C, besonders bevorzugt zwischen 40 und 100 °C.

Gegebenenfalls anwesende Lösungsmittel müssen unter den Reaktionsbedingungen inert sein. Als Lösungsmittel kommen u.a. aromatische Kohlenwasserstoffe, chlorierte Kohlenwasserstoffe, Ketone und Ether in Betracht. Beispiele dafür sind Benzol, Toluol, Xylol, Ethylbenzol, Isopropylbenzol, Ethylenchlorid, Propylenchlorid, Methylenchlorid, Chloroform, Methylethylketon, Aceton, Cyclohexanon, Diethylether oder Tetrahydrofuran.

Wie eingangs erwähnt, stellen die erfindungsgemässen Polymere wertvolle Materialien für positive Photoresists dar, die gegenüber Säuren eine sehr gute Empfindlichkeit aufweisen und zusammen mit säuregenerierenden Photoinitiaroren ein strahlungsempfindliches Gemisch bilden. Die Empfindlichkeit der erfindungsgemässen Polymere gegenüber Säuren wird auch in hohen Schichtdicken, beispielsweise im Bereich von etwa 30 µm, beibehalten. Die durch Säurespaltung aus den erfindungsgemässen Polymeren erhaltenen Verbindungen sind zudem in schwach basischen Entwicklerlösungen sehr gut löslich. Dagegen sind die erfindungsgemässen Polymere gegenüber diesen Basen sehr stabil, so dass im Photoresist eine sehr gute Differenzierung zwischen belichteten und unbelichteten Stellen erhalten wird.

Die Erfindung umfasst somit auch positiv arbeitende, strahlungsempfindliche Zusammensetzungen enthaltend, bezogen auf die Gesamtmenge der Komponenten a und b,
a) 80 bis 99,5 Gew.-% eines Polymers der Formel I und
b) 0,5 bis 20 Gew.-% einer unter Einwirkung von aktinischer Strahlung säurebildenden Substanz.

Bevorzugt sind Zusammensetzungen enthaltend, bezogen auf die Gesamtmenge der Komponenten a und b,
a) 90 bis 99,5 Gew.% eines Polymers der Formel I und
b) 0,5 bis 10 Gew.% einer unter Einwirkung von aktinischer Strahlung säurebildenden Substanz.

Als strahlungsempfindliche Komponenten b, die bei Lichteinwirkung Säure bilden bzw. abspalten, sind eine grosse Anzahl von Verbindungen bekannt. Dazu zählen beispielsweise Diazoniumsalze, wie sie in der Diazotypie verwendet werden, o-Chinondiazide, wie sie in bekannten positiv arbeitenden Kopiermassen verwendet werden, oder auch Halogenverbindungen, die bei Bestrahlung Halogenwasserstoffsäure bilden. Verbindungen dieses Typs sind beispielsweise in US-A 3,515,552, 3,536,489 oder 3,779,778, sowie in DE-A 27 18 259, 22 43 621 oder 26 10 842 beschrieben.

Als strahlungsempfindliche Komponenten b der erfindungsgemässen Zusammensetzungen eignen sich vor allem kationische Photoinitiatoren aus der Gruppe der Iodonium- oder Sulfoniumsalze. Solche Verbindungen sind beispielsweise in "UV-Curing, Science and Technology" (Editor: S.P. Pappas, Technology Marketing Corp., 642 Westover Road, Stanford, Connecticut, USA) beschrieben.

Ferner können Sulfoxoniumsalze als strahlungsempfindliche Verbindungen verwendet werden. Solche Salze sind beispielsweise in der EP-B 35,969 oder in der EP-A 44,274 bzw. 54,509 beschrieben. Insbesondere zu erwähnen sind aliphatische Sulfoxoniumsalze, die im tiefen UV-Bereich absorbieren.

Es lassen sich auch Verbindungen einsetzen, die bei Bestrahlung mit aktinischem Licht Sulfonsäuren freisetzen. Solche Verbindungen sind an sich bekannt und beispielsweise in der GB-A 2,120,263, den EP-A 84,515, 37,152 oder 58,638 bzw. in den US-A 4,258,121 oder 4,371,605 beschrieben.

Werden als strahlungsempfindliche säureabspaltende Komponenten b Salze eingesetzt, so sind diese vorzugsweise in organischen Lösungsmitteln löslich. Besonders bevorzugt handelt es sich bei diesen Salzen um Produkte mit komplexen Säuren, beispielsweise von Borfluorwasserstoffsäure, Hexafluorphosphorsäure, Trifluormethansulfonsäure, Hexafluorarsensäure oder Hexafluorantimonsäure.

Die erfindungsgemässen Zusammensetzungen können weiterhin übliche Zusatzstoffe enthalten, wie z.B. Stabilisatoren, Pigmente, Farbstoffe, Füllstoffe, Haftvermittler, Verlaufsmittel, Netzmitzel und Weichmacher. Ferner können die Zusammensetzungen zur Applikation in geeigneten Lösungsmitteln gelöst werden.

Die erfindungsgemässen Zusammensetzungen eignen sich hervorragend als Beschichtungsmittel für Substrate aller Art, z.B. Holz, Textilien, Papier, Keramik, Glas, Kunststoffe, wie Polyester, Polyethylenterephthalat, Polyolefine oder Celluloseacetat, insbesondere in Form von Filmen, sowie Metalle, wie Al, Cu, Ni, Fe, Zn, Mg oder Co, und GaAs, Si oder SiO₂, bei denen durch bildmässiges Belichten eine Abbildung aufgebracht werden soll.

Ein weiterer Gegenstand der vorliegenden Erfindung ist daher ein Verfahren zur Herstellung von positiven Abbildungen durch
- I.): Beschichtung eines Substrates mit einer erfindungsgemässen strahlungsempfindlichen Zusammensetzung,
- II.): Belichtung des beschichteten Substrates mit aktinischer Strahlung in einem vorbestimmten Muster und
- III.): Entwicklung des belichteten Substrates.

Die Beschichtung der Substrate kann z.B. erfolgen, indem man eine Lösung oder Suspension der erfindungsgemässen Zusammensetzung auf das Substrat appliziert.

Die Wahl des Lösungsmittels und die Konzentration richtet sich hauptsächlich nach der Art der Zusammensetzung und nach dem Beschichtungsverfahren. Die Lösung wird mittels bekannter Beschichtungsverfahren auf ein Substrat gleichförmig aufgebracht, z.B. durch Schleudern, Tauchen, Rakelbeschichtung, Vorhanggiessverfahren, Aufpinseln, Sprühen, speziell durch elektrostatisches Sprühen und Reverse-Rollbeschichtung. Es ist auch möglich, die strahlungsempfindliche Schicht auf einen temporären, flexiblen Träger zu bringen, und dann durch Schichtübertragung via Lamination das endgültige Substrat, z.B. eine kupferkaschierte Leiterplatte, zu beschichten.

Die Auftragsmenge (Schichtdicke) und Art des Substrates (Schichtträger) sind abhängig vom gewünschten Applikationsgebiet. Besonders vorteilhaft ist es, dass die erfindungsgemässen Zusammensetzungen in sehr variablen Schichtdicken eingesetzt werden können. Dieser Schichtdickenbereich umfasst Werte von ca. 0,5 µm bis mehr als 100 µm. Mit konventionellen Positiv-Systemen auf Naphthochinondiazid-Basis sind Schichtdicken von grösser als 10 µm nicht mehr verwendbar.

Nach dem Beschichten wird das Lösungsmittel in der Regel durch Trocknen entfernt, und es resultiert eine Schicht des Photoresists auf dem Träger.

Nach der in üblicher Weise erfolgten bildmässigen Belichtung des Materials werden die belichteten Stellen des Photolackes durch Herauslösen in einem Entwickler entfernt.

Der Begriff 'bildmässige' Belichtung beinhaltet sowohl die Belichtung durch eine Photomaske, die ein vorbestimmtes Muster enthält, beispielsweise ein Diapositiv, die Belichtung durch einen Laserstrahl, der beispielsweise computergesteuert über die Oberfläche des beschichteten Substrates bewegt wird, und auf diese Weise ein Bild erzeugt, sowie die Bestrahlung mit computergesteuerten Elektronenstrahlen oder die Behandlung mit Röntgenstrahlen durch eine Absorbermaske hindurch.

Die Lichtempfindlichkeit der erfindungsgemässen Zusammensetzungen reicht in der Regel vom UV-Gebiet (ca. 200 nm) bis ca. 600 nm und umspannt somit einen sehr breiten Bereich. Insbesondere im DUV-Bereich (200-300 nm) weisen die erfindungsgemässen Zusammensetzungen eine ausgezeichnete Transparenz auf. Als Lichtquellen kommen daher eine grosse Anzahl der verschiedensten Typen zur Anwendung. Es sind sowohl Punktlichtquellen als auch flächenförmige Strahler (Lampenteppiche) geeignet. Beispiele sind: Kohlelichtbogenlampen, Xenon-Lichtbogenlampen, Quecksilberdampflampen, gegebenenfalls mit Metall-Halogeniden dotiert (Metall-Halogenlampen), Fluoreszenzlampen, Argonglühlampen, Elektronenblitzlampen, photographische Flutlichtlampen, Elektronenstrahlen und Röntgenstrahlen. Der Abstand zwischen Lampe und erfindungsgemässem Bildmaterial kann je nach Anwendungszweck und Lampentyp bzw. -stärke variieren, z.B. zwischen 2 cm bis 150 cm. Speziell geeignet sind Laserlichtquellen, z.B. Argonionenlaser oder Krypronionenlaser. Bei dieser Art der Belichtung ist eine Photomaske im Kontakt mit der Photopolymerschicht nicht mehr unbedingt nötig; der gesteuerte Laser-Strahl schreibt direkt auf die Schicht. Hier ist die hohe Empfindlichkeit der erfindungsgemässen Materialien sehr vorteilhaft, die hohe Schreibgeschwindigkeiten bei relativ niedrigen Intensitäten erlaubt. Nach dieser Methode können gedruckte Schaltungen in der Elektronikindustrie, lithographische Offsetdruckplatten oder Reliefdruckplatten sowie photographische Bildaufzeichnungsmaterialien hergestellt werden.

Die Wahl des jeweiligen Entwicklers richtet sich nach der Art des Photolackes oder der entstehenden Photolyseprodukte. Der Entwickler kann wässrige Lösungen von Basen umfassen, denen gegebenenfalls organische Lösungsmittel oder deren Mischungen zugesetzt werden.

Besonders bevorzugt als Entwickler werden wässrig-alkalische Lösungen, wie sie auch für die Entwicklung von Naphthochinondiazidschichten eingesetzt werden. Dazu zählen insbesondere wässrige Lösungen von Alkalimetallsilikaten, -phosphaten, -hydroxiden, -carbonaten und -hydrogencarbonaten. Diesen Lösungen können gegebenenfalls noch kleinere Mengen an Netzmitteln und/oder organischen Lösungsmitteln zugesetzt sein.

Typische organische Lösungsmittel, die den Entwicklerflüssigkeiten zugesetzt werden können, sind beispielsweise Cyclohexanon, 2-Ethoxyethanol, Toluol, Aceton, sowie Mischungen zweier oder mehrerer dieser Lösungsmittel.

Mögliche Einsatzgebiete der erfindungsgemässen Zusammensetzungen sind die Verwendung als Photoresists für die Elektronik (Galvanoresist, Aetzresist, Lötstoppresist), die Herstellung von Druckplatten, wie Offsetdruckplatten oder Siebdruckformen, der Einsatz beim Formteilätzen oder der Einsatz als Mikroresist bei der Herstellung integrierter Schaltkreise. Dementsprechend unterschiedlich sind die möglichen Schichtträger und die Verarbeitungsbedingungen der beschichteten Substrate.

Für photographische Informationsaufzeichnung dienen z.B. Folien aus Polyester, Celluloseacetat oder mit Kunststoff beschichtete Papiere; für Offsetdruckformen speziell behandeltes Aluminium, für die Herstellung gedruckter Schaltungen kupferkaschierte Laminate und für die Herstellung von integrierten Schaltkreisen Siliziuimwafer. Die Schichtdicken für photographische Materialien und Offsetdruckformen betragen ca 0,5 µm bis 10 µm; für gedruckte Schaltungen 1 µm bis ca. 100 µm und für integrierte Schaltkreise 0,5 µm bis 2 µm.

Gegenstand der Erfindung ist daher die Verwendung der erfindungsgemässen Zusammensetzungen als Positiv-Resist für die Herstellung von Druckformen, gedruckten Schaltungen oder integrierten Schaltkreisen, sowie für silberlose photographische Filme.

Die Erfindung betrifft weiterhin auch die unter Verwendung besagter Zusammensetzungen hergestellten Druckformen, gedruckten Schaltungen, integrierten Schaltkreise oder silberlosen photographischen Filme.

Die folgenden Beispiele illustrieren die vorliegende Erfindung weiter.

### I. Herstellung der Monomere

### Beispiel A: Synthese von 4-Vinylphenylessigsäuretert.-butylester

a) 4-Vinylphenylessigsäurechlorid:
100 g (0,62 mol) 4-Vinylphenylessigsäure werden in 600 ml Essigsäureethylester gelöst. Zu dieser Lösung werden 1 g Hydrochinon und 10 Tropfen Dimethylformamid gegeben. Zu dieser Lösung werden 70,2 g (0,59 mol) Thionylchlorid zugetropft. Danach wird 5 Stunden bei 70 °C gerührt. Das Lösungsmittel wird dann am Rotationsverdampfer entfernt. Anschliessend wird die Flüssigkeit bei 69 °C im Hochvakuum (6,7 Pa) destilliert.
Ausbeute: 73 g (67 % der Theorie).

| | | | |
|---|---|---|---|
| Elementaranalyse: | ber.: C 66,49 %; | H 5,02 % | Cl 19,53 %. |
| | gef.: C 66,38 %; | H 5,08 % | Cl 19,55 %. |

¹H-NMR (CDCl₃): 4,09 ppm, s (-C**H**₂-CO-); 5,28, 5,29 und 5,70, 5,76 ppm, m (C**H**₂=); 6,64-6,73 ppm, m (=C**H**-); 7,11-7,41 ppm, m (Aryl-**H**).

b) 4-Vinylphenylessigsäuretert.-butylester:
Zu einer Mischung von 9,3 g (125 mmol) tert.-Butanol, 25 g Na₂CO₃ und 2 g Benzyltriethylammoniumchlorid in 100 ml Methylenchlorid werden 15 g (83 mmol) 4-Vinylphenylessigsäurechlorid getropft. Anschliessend wird 2,5 Stunden bei 50 °C gerührt. Die festen Anteile werden danach abfiltriert. Die organische Phase wird je zweimal mit Wasser und einer 5%-igen NaHCO₃-Lösung gewaschen. Die über Na₂SO₄ getrocknete organische Phase wird filtriert und das Lösungsmittel abgedampft. Die Flüssigkeit wird im Kugelrohr bei 100 °C/6,7 Pa destilliert. Es wird eine klare Flüssigkeit erhalten (GC-Reinheit > 99,5 %).
Ausbeute: 9 g (50 % der Theorie).

| | | |
|---|---|---|
| Elementaranalyse: | ber.: C 77,03 %; | H 8,31 %. |
| | gef.: C 76,94 %; | H 8,47 %. |

¹H-NMR (CDCl₃): 1,42 ppm, s (-C(C**H**₃)₃); 3,49 ppm, s (-C**H**₂-CO-); 5,18, 5,21 und 5,67, 5,73 ppm, m (C**H**₂=); 6,63-6,72 ppm, m (=C**H**-); 7,19-7,35 ppm, m (Aryl-**H**).

### II. Herstellung der Polymere

Beispiel 1: Synthese von Poly-(4-Vinylphenylessigsäuretert.-butylester) 21,8 g (100 mmol) 4-Vinylphenylessigsäuretert.-butylester (Beispiel A) werden mit 164 mg (1 mol-%) AIBN in 80 ml Toluol gelöst und in eine Glasampulle gegeben. Bei -78°C wird zweimal entgast und die Ampulle im Hochvakuum zugeschmolzen. Bei 65°C wird 18 Stunden lang polymerisiert. Der Ampulleninhalt wird anschliessend mit n-Hexan ausgefällt. Danach wird das Polymer abgetrennt, getrocknet, nochmals in Toluol gelöst und wiederum mit n-Hexan ausgefällt.
Ausbeute: 12 g (55 % der Theorie).
GPC (THF): M_{w} = 49000; Mₙ =25500; M_{w}/Mₙ = 1,92.

| | | |
|---|---|---|
| Elementaranalyse: | ber.: C 77,03 %; | H 8,31 %. |
| | gef.: C76,84 %; | H 8,26 %. |

TGA (Luft, 10 °C/min):
Bei 180 °C wird die Abspaltung von Isobutylen festgestelllt (Masseverlust ≈ 25 %).
DSC (Luft, 10 °C/min):
Bei 182 °C ist ein stark endothermer Peak sichtbar, der auf die Abspaltung von Isobutylen hinweist.
Absorption eines Polymerfilms auf Quarz:
Bei 254 nm Wellenlänge zeigt ein 1 Mikron dicker Polymerfilm eine Absorption von 0,16 pro Mikron.

## Patentansprüche

1. Polymere mit einem Molekulargewicht (M_{w}) von 10³ bis 10⁶, gemessen mittels Gelpermeationschromatographie, enthaltend, bezogen auf die Gesamtmenge der im Polymer vorhandenen Strukturelemente, 100 bis 10 Mol-% des wiederkehrenden Strukturelementes der Formel I 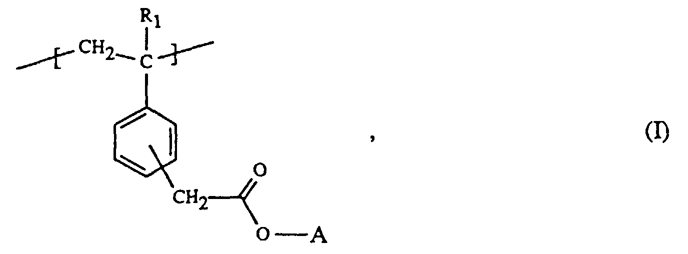 wobei A für einen Rest der Formel Ia 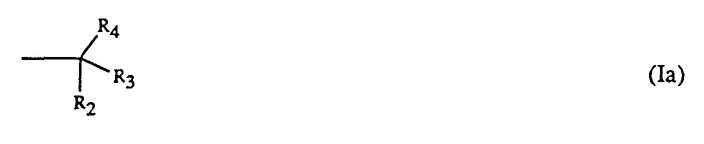 steht, und 90 bis 0 Mol-% des wiederkehrenden Strukturelementes der Formel II 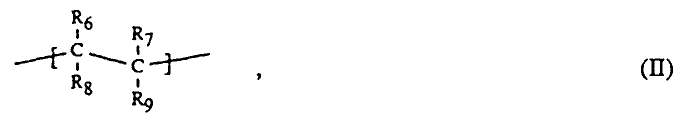 worin
R₁ Wasserstoff, Methyl oder Halogen,
R₂ Wasserstoff oder Methyl,
R₃ Wasserstoff, C₁-C₆-Alkyl oder C₆-C₁₂-Aryl und
R₄ C₁-C₆-Alkyl, unsubstituiertes oder mit C₁-C₄-Alkyl, C₁-C₄-Alkoxy, C₆-C₁₂-Aryl, Halogen oder Nitrogruppen substituiertes C₆-C₁₂-Aryl darstellt,
R₆ und R₇ unabhängig voneinander jeweils Wasserstoff, unsubstituiertes oder mit Halogen, Cyano- oder Nitrogruppen substituiertes C₁-C₄-Alkyl oder ein unsubstituiertes oder mit Halogen, C₁-C₄-Alkoxy-, Hydroxy-, Cyano- oder Nitrogruppen substituiertes Phenyl oder Naphthyl bedeuten,
R₈ und R₉ unabhängig voneinander jeweils Wasserstoff oder Halogen, unsubstituiertes oder durch Halogen, Cyano- oder Nitrogruppen substituiertes C₁-C₁₂-Alkyl, unsubstituiertes oder durch Halogen, Hydroxy-, Cyano-, Nitrogruppen, C₁-C₄-Alkyl oder C₁-C₄-Alkoxy substituiertes Phenyl, Naphthyl oder Benzyl oder einen der folgenden Reste -OR₁₀, -COOR₁₁ oder -COR₁₂ bedeuten, wobei R₁₀ und R₁₁ unabhängig voneinander jeweils Wasserstoff, unsubstituiertes oder durch Halogen, Cyano- oder Nitrogruppen substituiertes C₁-C₁₂-Alkyl, unsubstituiertes oder durch Halogen, Cyano-, Nitrogruppen, C₁-C₄-Alkyl oder C₁-C₄-Alkoxy substituiertes Phenyl oder Naphthyl bedeuten und R₁₂ die gleiche Bedeutung wie R₁₀ hat und ausserdem für den Rest 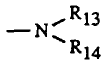 steht, worin R₁₃ und R₁₄ unabhängig voneinander die gleiche Bedeutung wie R₁₀ haben.

2. Polymere gemäss Anspruch 1, enthaltend 100 bis 25 Mol-% des wiederkehrenden Strukturelementes der Formel I und 75 bis 0 Mol-% des wiederkehrenden Strukturelementes der Formel II.

3. Polymere gemäss Anspruch 1, worin in der Formel I R₁ Wasserstoff oder Methyl bedeutet und die Gruppe -CH₂-COOA am Ring in para-Stellung gebunden ist, und worin in der Formel Ia R₂ Wasserstoff oder Methyl, R₃ Wasserstoff oder C₁-C₄-Alkyl und R₄ Wasserstoff oder C₁-C₄-Alkyl darstellt.

4. Polymere gemäss Anspruch 1, worin in den Formel I R₁ Wasserstoff oder Methyl bedeutet und die Gruppe -CH₂-COOA am Ring in para-Stellung gebunden ist, und worin in der Formel Ia R₂ und R₃ unabhängig voneinander jeweils Wasserstoff oder Methyl bedeuten und R₄ C₁-C₄-Alkyl darstellt.

5. Polymere gemäss Anspruch 1, worin in der Formel I R₁ Wasserstoff oder Methyl bedeutet und die Gruppe -CH₂-COOA am Ring in para-Stellung gebunden ist, und worin A einen Rest der Formel 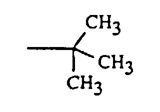 bedeutet.

6. Strahlungsempfindliche Zusammensetzungen enthaltend, bezogen auf die Gesamtmenge der Komponenten a und b,
a) 80 bis 99,5 Gew.-% eines Polymers gemäss Anspruch 1 und
b) 0,5 bis 20 Gew.-% einer unter Einwirkung von aktinischer Strahlung säurebildenden Substanz.

7. Zusammensetzungen gemäss Anspruch 6, enthaltend, bezogen auf die Gesamtmenge der Komponenten a und b,
a) 90 bis 99,5 Gew.% eines Polymers gemäss Anspruch 1 und
b) 0,5 bis 10 Gew.% einer unter Einwirkung von aktinischer Strahlung säurebildenden Substanz.

8. Verfahren zur Herstellung von positiven Abbildungen durch
I.) Beschichtung eines Substrates mit einer strahlungsempfindlichen Zusammensetzung gemäss Anspruch 6,
II.) Belichtung des beschichteten Substrates mit aktinischer Strahlung in einem vorbestimmten Muster und
III.) Entwicklung des belichteten Substrates.

9. Verwendung der Zusammensetzungen gemäss Anspruch 6 als Positiv-Resist für die Herstellung von Druckformen, gedruckten Schaltungen oder integrierten Schaltkreisen, sowie für silberlose photographische Filme.

10. Die unter Verwendung der Polymere gemäss Anspruch 1 hergestellten Druckformen, gedruckten Schaltungen, integrierten Schaltkreise oder silberlosen photographischen Filme.

## Claims

1. Polymers having a molecular weight (M_{w}) of 10³ to 10⁶, determined by gel permeation chromatography, said polymers containing, based on the total number of structural units present in the polymer, 100 to 10 molar % of the structural repeating unit of formula I 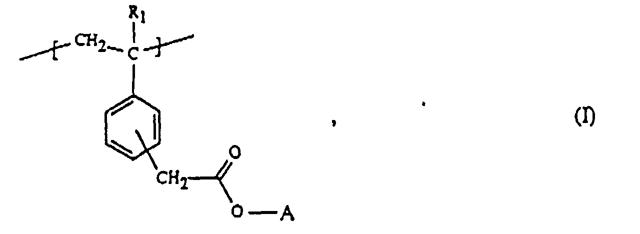 wherein A is a radical of formula Ia 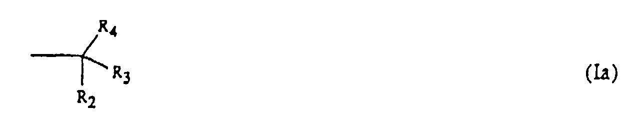 and 90 to 0 molar % of the structural repeating unit of formula II 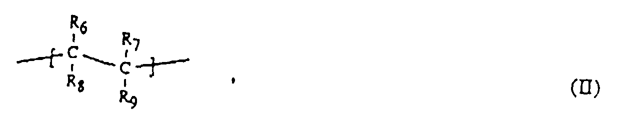 wherein
R₁ is hydrogen, methyl or halogen,
R₂ is hydrogen or methyl,
R₃ is hydrogen, C₁-C₆ alkyl or C₆-C₁₂ aryl, and
R₄ is C₁-C₆ alkyl, unsubstituted C₆-C₁₂ aryl or C₈-C₁₂ aryl which is substituted by C₁-C₄ alkyl, C₁-C₄ alkoxy, C₆-C₁₂ aryl, halogen or nitro groups
R₆ and R₇ are each independently of the other hydrogen, unsubstituted C₁-C₄ alkyl or C₁-C₄ alkyl which is substituted by halogen, cyano or nitro, or are unsubstituted phenyl or naphthyl or phenyl or naphthyl which are each substituted by halogen, C₁-C₄ alkoxy, hydroxy, cyano or nitro groups;
R₈ and R₉ are each independently of the other hydrogen or halogen, unsubstituted C₁-C₁₂ alkyl or C₁-C₁₂ alkyl which is substituted by halogen, cyano or nitro groups; phenyl, naphthyl or benzyl, each unsubstituted or substituted by halogen, hydroxy, cyano, nitro groups, C₁-C₄ alkyl or C₁-C₄ alkoxy, or are a radical selected from the group consisting of -OR₁₀, -COOR₁₁ and -COR₁₂, wherein R₁₀ and R₁₁ are each independently of the other hydrogen, unsubstituted C₁-C₁₂alkyl or C₁-C₁₂alkyl which is substituted by halogen, cyano or nitro groups; unsubstituted phenyl or naphthyl or phenyl or naphthyl which are each substituted by halogen, cyano, nitro groups, C₁-C₄ alkyl or C₁-C₄ alkoxy, and R₁₂ has the same meaning as R₁₀ and is also the radical 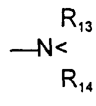 wherein R₁₃ and R₁₄, each independently of the other, have the same meaning as R₁₀.

2. Polymers according to claim 1, containing 100 to 25 molar % of the structural repeating unit of formula I and 75 to 0 molar % of the structural repeating unit of formula II.

3. Polymers according to claim 1, wherein R₁ in formula I is hydrogen or methyl and the group -CH₂-COOA is in para-position at the ring, and in formula Ia R₂ is hydrogen or methyl, R₃ is hydrogen or C₁-C₄ alkyl and R₄ is hydrogen or C₁-C₄ alkyl.

4. Polymers according to claim 1, wherein R₁ in formula I is hydrogen or methyl, and the group -CH₂-COOA is in para-position at the ring, and wherein R₂ and R₃ in formula Ia are each independently of the other hydrogen or methyl and R4 is C₁-C₄ alkyl.

5. Polymers according to claim 1, wherein R₁ in formula I is hydrogen or methyl and the group -CH₂-COOA is in para-position at the ring, and A is a radical of formula

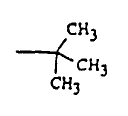

6. Radiation-sensitive compositions containing, based on the total amount of components a) and b),
a) 80 to 99.5% by weight of a polymer according to claim 1, and
b) 0.5 to 20% by weight of a substance which generates an acid upon exposure to actinic radiation.

7. Compositions according to claim 6, containing, based on the total amount of components a and b,
a) 90 to 99.5% by weight of a polymer according to claim 1, and
b) 0.5 to 10% by weight of a substance which generates an acid upon exposure to actinic radiation.

8. A process for producing positive images by
1.) coating a substrate with a radiation-sensitive composition according to claim 6,
II.) exposing the coated substrate to irradiation with actinic light in a predetermined pattern, and
III.) developing the irradiated substrate.

9. Use of the compositions according to claim 6 as positive resists for the production of printing forms, printed circuits or integrated circuits, as well as for silver-free photographic films.

10. The printing forms, printed circuits, integrated circuits or silver-free photographic films produced with the use of polymers according to claim 1.

## Revendications

1. Des polymères ayant une masse moléculaire (M_{w}) de 10³ à 10⁶, déterminee par la méthode de la chromatographie d'exclusion stérique (de perméation de gel, GPC); ces polymères contiennent un pourcentage molaire compris, suivant le nombre total d'unités structurales présentes dans le polymère, entre 100 et 10 % de l'unité structurellement répétitive de la formule I. 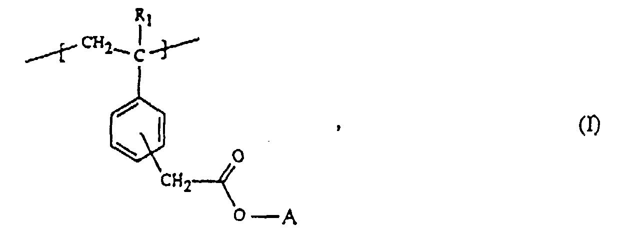 où A est un radical de la formule Ia 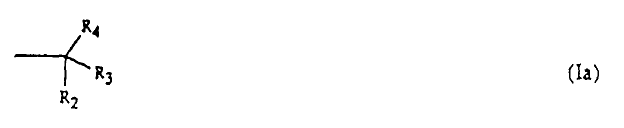 et un pourcentage molaire compris entre 90 et 0 % de l'unité structurellement répétitive de la formule II 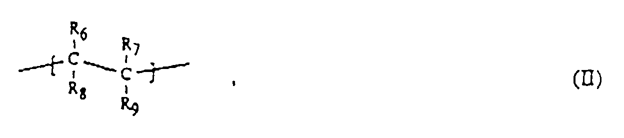 où
R₁ est de l'hydrogène, du méthyle ou de l'halogène,
R₂ est de l'hydrogène ou du méthyle,
R₃ est de l'hydrogène, de l'alkyle C₁-C₆ ou de l'aryle C₆-C₁₂ et
R₄ est de l'alkyle C₁-C₆, de l'aryle non substitué C₆-C₁₂ ou de l'aryle C₆-C₁₂ auquel est substitué de l'alkyle C₁-C₄, de l'alkoxy C₁-C₄, de l'aryle C₆-C₁₂, ou un groupe d'halogène ou nitro,
R₆ et R₇ sont chacun indépendants de l'autre hydrogène, de l'alkyle non substitué C₁-C₄ ou de l'alkyle C₁-C₄ auquel est substitué un groupe d'halogène, cyano ou nitro, ou qui sont du phényle ou du naphtyle non substitué, ou du phényle ou du naphtyle auquel on a substitué à chacun des groupes d'halogène, d'alkoxy C₁-C₄ d'hydroxy, cyano ou nitro ;
R₈ et R₉ sont chacun indépendants de l'autre hydrogène ou halogène, de l'alkyle C₁-C₁₂ non substitué ou de l'alkyle C₁-C₁₂ auquel a été substitué de l'halogène, du cyano ou du nitro ; du phényle, du naphtyle ou du benzyle, chacun étant remplacé ou non remplacé par de l'halogène, hydroxy, cyano, nitro, alkyle C₁-C₄ ou de l'alkoxy C₁-C₄, ou ils sont in radical sélectionné au sein du groupe consistant en -OR₁₀, -COOR₁₁ ou -COR₁₂, où R₁₀ et R₁₁ sont chacun indépendants de l'autre hydrogène, de l'alkyle non substitué C₁-C₁₂ ou de l'alkyle C₁-C₁₂ auquel est substitué de l'halogène, du cyano ou du nitro ; du phényle ou du naphtyle non substitué, ou du phényle ou du naphtyle ayant chacun été remplacé par de l'halogène, du cyano, du nitro, de l'alkyle C₁-C₄ ou de l'alkoxy C₁-C₄ 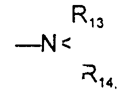 et où R₁₂ a la même signification que R₁₀ et est également le radical où R₁₃ et R₁₄, chacun étant indépendant de l'autre, avec la même signification que R₁₀.

2. Les polymères conformément à la revendication 1, ayant un pourcentage molaire compris entre 100 et 25 % de l'unité structurellement répétitive de la formule 1 et un pourcentage molaire compris entre 75 et 0 % de l'unité structurellement répétitive de la formule II.

3. Les polymères conformément à la revendication 1, où R₁ dans Ia formule I est de l'hydrogène ou du méthyle et le groupe -CH₂-COOA est en para-position sur l'anneau, et où, dans la formule la, R₂ est de l'hydrogène ou du méthyle, R₃ est de de l'hydrogène ou de l'alkyle C₁-C₄ et R₄ est de l'hydrogène ou de l'alkyle C₁-C₄

4. Les polymères conformément à la revendication 1, R₁ où dans la formule I est de l'hydrogène ou du méthyle, où le groupe -CH₂-COOA est en pars-position sur l'anneau, et où R₂ et R₃ dans la formule la sont chacun indépendants de l'autre de l'hydrogène ou du méthyle et où R₄ est de l'alkyle C₁-C₄.

5. Les polymères conformément à la revendication 1, où R, dans la formule I est de l'hydrogène ou du méthyle, où le groupe -CH₂-COOA est en para-position sur l'anneau et où A est le radical de la formule

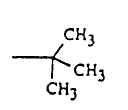

6. Les compositions sensibles aux rayonnements contenant, sur la base du montant total des composants a) et b),
a) de 80 à 99,5 % au poids d'un polymère conformément à la revendication 1 et
b) de 0,5 à 20 % au poids d'une substance qui produit un acide à la suite de son exposition aux rayonnements actiniques.

7. Les compositions conformément à la revendication 6, contenant, sur la base du montant total des composants a et b,
a) de 90 à 99,5 % au poids d'un polymère conformément à la revendication 1 et
b) de 0,5 à 10 % au poids d'une substance qui produit un acide à la suite de son exposition aux rayonnements actiniques.

8. Un processus permettant la production d'images positives en
1.) revêtant un substrat d'une composition sensible aux rayonnements conformément à la revendication 6,
II.) exposant le substrat ainsi revêtu à des rayonnements avec de la lumière actinique selon un modèle prédéterminé et
III.) révélant le substrat qui a été irradié.

9. L'utilisation de compositions conformément à la revendication 6 afin qu'elles servent d'agents résistants positifs pour Ia production de clichés d'impression, de circuits imprimés ou de circuits intégrés, ainsi que de films photographiques sans argent.

10. Les clichés d'impression, les circuits imprimés, les circuits intégrés et les films photographiques sans argent qui ont été produits avec l'emploi des polymères conformément à la revendication 1.
